Europäisches Patentamt

European Patent Office

Office européen des brevets

(19)

(11) Numéro de publication: **0 322 065**
**A1**

## (12) DEMANDE DE BREVET EUROPEEN

(21) Numéro de dépôt: **88202953.1**

(22) Date de dépôt: **19.12.88**

(51) Int. Cl.⁴: **G09G 1/00 , G09G 1/16**

(30) Priorité: **23.12.87 FR 8718041**

(43) Date de publication de la demande:
**28.06.89 Bulletin 89/26**

(84) Etats contractants désignés:
**DE FR GB IT SE**

(71) Demandeur: **Laboratoires d'Electronique et
de Physique Appliquée L.E.P.
3, Avenue Descartes
F-94450 Limeil-Brévannes(FR)**

(84) **FR**

Demandeur: **N.V. Philips'
Gloeilampenfabrieken
Groenewoudseweg 1
NL-5621 BA Eindhoven(NL)**

(84) **DE GB IT SE**

(72) Inventeur: **Callemyn, Jean-Michel
Société Civile S.P.I.D. 209, Rue de
l'Université
F-75007 Paris(FR)**

(74) Mandataire: **Hoarau de La Source, Jean Marie
Pierre et al
S.P.I.D. 209, rue de l'Université
F-75007 Paris(FR)**

(54) **Système graphique avec controleur graphique et controleur de DRAM.**

(57) Le système graphique comporte notamment :
- un processeur d'écran (DCLP) lequel formule séparément les demandes d'accès à un seul mot (REQ3) et les demandes d'accès à plusieurs mots consécutifs (RAF).
- un arbitre de bus (BUSAR) pour arbitrer les demandes d'accès à un seul mot et sélectionner une demande (REQ-S).
- un contrôleur de DRAM (CT.DRAM) pour arbitrer la dite REQ-S, les demandes à plusieurs mots (RAF) et les demandes de rafraîchissement (REQ-FR).

Le contrôleur de DRAM est, de préférence, constitué d'un automate qui génère directement les signaux RAS, CAS. L'automate est préférentiellement réalisé sous forme de PLA.

FIG. 1

## SYSTEME GRAPHIQUE AVEC CONTROLEUR GRAPHIQUE ET CONTROLEUR DE DRAM.

La présente invention a pour objet un système graphique comportant, connectés entre eux par bus de données, commande et adresse, un micro-ordinateur de commande à mémoire de programme pour commander le système, un écran de visualisation graphique, une mémoire vive dynamique (ci-après DRAM) pour mémoriser des mots d'information d'affichage et un contrôleur graphique comprenant :

- un processeur graphique (MCLP)
- un processeur d'écran (DCLP), associé à un générateur de synchronisation, pour, en se synchronisant avec le balayage de chaque ligne de l'écran, lire les mots d'information à afficher,
- un interface micro-ordinateur,
- un contrôleur de DRAM,

le dit contrôleur de DRAM comportant des moyens de génération pour générer, selon chaque demande d'accès, des séquences de signaux de contrôle, notamment contrôle de ligne (RAS) et contrôle de colonne (CAS), de la DRAM, chaque demande pouvant être soit une demande de rafraîchissement en provenance du dit processeur d'écran (DCLP), soit une demande de lecture des informations d'une fenêtre en provenance du dit processeur d'écran (DCLP), soit encore une demande d'accès à un seul mot (REQ1, REQ2) en provenance du processeur graphique (MCLP) ou en provenance du micro-ordinateur de commande via le dit interface, et des moyens d'arbitrage pour arbitrer les dites demandes lesquelles peuvent être simultanées alors que leurs exécutions ne sauraient l'être.

Les systèmes graphiques sont bien connus dans l'industrie de la visualisation d'images sur des écranscathodiques à balayage ligne à ligne; les éléments d'images, ou pixels, étant mémorisés dans une mémoire dynamique DRAM.

Dans un tel système graphique, la mémoire DRAM est sollicitée, en lecture et en écriture, par divers modules de traitement qui formulent des demandes d'accès; ces demandes peuvent être simultanées alors que leurs exécutions ne sauraient l'être et il est donc nécessaire de prévoir des moyens d'arbitrage; pour ce faire, un système logique de priorité connu est décrit dans la demande de brevet français n° 2 593 304 dont on constate la mise en oeuvre dans le contrôleur graphique INTEL n° 82786 tel que décrit dans la brochure technique AP270 notamment p.19; ce système connu prévoit divers registres paramétrables selon le choix de l'utilisateur pour affecter des priorités aux demandes d'accès; cette solution est relativement complexe et l'utilisateur doit procéder par essais successifs pour trouver les paramètres les plus performants, de plus la réalisation technique du dispositif décrit est relativement chère.

La présente invention a pour but de proposer un système graphique dont la gestion des priorités d'accès est telle que l'utilisateur a la certitude qu'il n'y a pas de temps mort lors de l'exécution, et telle que sa réalisation technique est simple et compacte donc économique.

Un système graphique conforme à l'invention est particulièrement remarquable en ce que chaque dite demande de lecture des informations d'une fenêtre est décomposée en d'une part au moins une demande d'accès à un seul mot (REQ3) pour lire la description de la dite fenêtre, et d'autre part une demande de lecture en rafale (RAF) de plusieurs mots pour lire les pixels de la dite fenêtre, et en ce que les dits moyens d'arbitrage, comportent des premiers moyens d'arbitrage (BUSAR), ci-après interface de bus interne, pour effectuer une pré-sélection entre les dites demandes d'accès à un seul mot (REQ1, REQ2, REQ3) et ainsi sélectionner l'une d'elles (REQS), et des deuxièmes moyens d'arbitrage (AUTO) pour arbitrer entre la dite demande pré-sélectionnée (REQS), une demande de rafraîchissement (REQFR) et une demande de lecture en rafale (RAF), et ainsi élire une demande élue à exécuter, et en ce que les dits deuxièmes moyens d'arbitrage et les dits moyens de génération sont confondus dans un même module (AUTO) comportant un automate à nombre d'états fini.

Ainsi, selon l'invention, les accès du système graphique à la DRAM sont gérés par deux systèmes complémentaires d'arbitrage; les premiers moyens d'arbitrage arbitrent exclusivement entre les accès à un seul mot de mémoire, aussi appelés accès lents, tandis que les deuxièmes moyens d'arbitrage arbitrent essentiellement entre les accès en rafale, aussi appelés accès rapides, et l'accès pré-sélectionné à un seul mot ce qui permet de privilégier les accès d'affichage proprement dit de telle sorte que la lecture des pixels dans la DRAM ne retarde jamais l'affichage des pixels sur l'écran; la jonction dans un même module des deuxièmes moyens d'arbitrage et des moyens de générations des séquences de signaux de contrôle résulte en ce que il n'y a pas de temps mort entre la prise de décision d'arbitrage et son exécution; il en résulte également une réalisation technique compacte.

Il est connu que le rafraîchissement périodique de la DRAM soit toujours prioritaire et ait lieu à date fixe pendant le, ou au début du, retour ligne du balayage de l'écran.

Selon l'invention, dans un mode de réalisation préféré, le dit processeur d'écran est pourvu de moyens pour détecter la date à laquelle tous les pixels de la dernière fenêtre de chaque ligne d'écran ont été lus dans la DRAM, et, dans ce cas, générer immédiatement, c'est à dire sans attendre une date fixe de fin d'affichage, une demande de rafraîchissement.

En conservant la plus haute priorité à la demande de rafraîchissement de la DRAM, l'exécution de cette demande va commencer le plus tôt possible, sans attendre le début du retour ligne, de telle sorte que la DRAM ne reste pas inactive, ou mal employée, dans l'intervalle de temps qui sépare la fin de la lecture des derniers pixels d'une ligne et la fin de leur affichage; ainsi le rafraîchissement s'effectue, selon l'invention, non plus à date fixe, mais à date mobile, dès que possible, tout en respectant la périodicité moyenne d'un rafraîchissement à chaque retour ligne.

Dans le système connu déjà cité, la gestion des priorités est paramétrable selon le choix de l'utilisateur.

Selon la présente invention, et dans un mode préféré de réalisation, les dits premiers moyens d'arbitrage entre les demandes d'accès à un seul mot sont agencés pour permettre des priorités différentes selon que le système se trouve en période d'affichage, en période de rafraîchissement, en période de retour ligne, ou en période de retour trame.

Ainsi il est possible d'optimiser les accès à la DRAM avec le maximum de finesse sans que l'utilisateur ait besoin de rechercher le meilleur choix.

Le débit, en lecture rapide, des pixels de la DRAM est supérieur au débit d'affichage des pixels sur l'écran, et, à cet effet, le processeur d'écran comporte une mémoire premier entré premier sorti FIFO qui émet un signal lorsqu'elle est pleine. Selon l'invention, à la réception de ce signal, l'automate d'arbitrage et de génération est agencé pour interrompre la lecture en rafale en cours et, le cas échéant, satisfaire une éventuelle demande d'accès pré-sélectionnée en attente.

Ainsi même lors de la période graphique pendant laquelle les accès en rafale ont la plus haute priorité, la DRAM ne reste pas inutilisée même lorsqu'il y a un temps d'attente.

Une DRAM peut être organisée, au choix de l'utilisateur, selon un mode d'organisation à choisir parmi soit le mode quatre bit, soit le mode page, et, dans le cas du mode page, avec ou sans entrelacement des bancs mémoire, le dit choix étant initialement effectué à l'initiative du microordinateur de commande puis mémorisé dans des registres du contrôleur de DRAM. Selon un mode préférentiel de réalisation, le dit automate est connecté aux dits registres et est agencé pour générer des séquences de signaux de contrôle de la DRAM conformes au dit choix du mode d'organisation.

Ainsi un système graphique conforme à l'invention est adaptable aux divers choix de l'utilisateur tout en lui garantissant une optimisation de la gestion des accès à la DRAM.

Selon un mode préférentiel, l'automate est réalisé sous forme de PLA ce qui minimise l'utilisation de surface de silicium et, de ce fait, garantit une réalisation technique simple et économique.

La présente invention sera mieux comprise à l'aide de la description non limitative d'un exemple de réalisation illustré par des dessins; la description comporte 3 tableaux A, B et C.

La figure 1 représente l'architecture générale d'un système graphique selon l'invention.

La figure 2 représente une partie de la figure 1 dont notamment le contrôleur de DRAM et son implantation dans le système graphique.

La figure 3 représente un diagramme des priorités en fonction des périodes de temps.

La figure 4 représente le diagramme des états de l'automate.

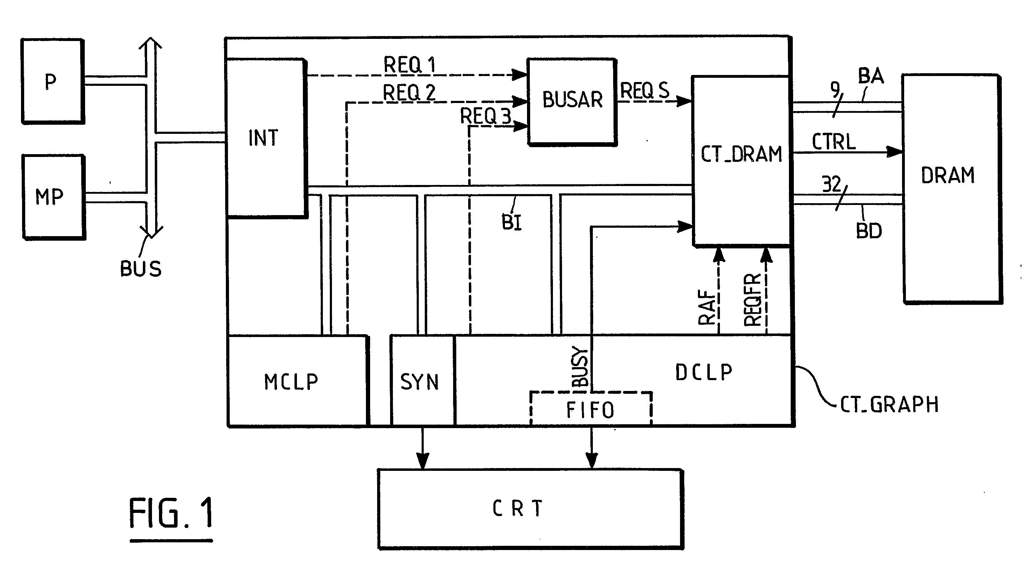

Sur le schéma de la figure 1, le système graphique représenté comporte un microprocesseur (P), par exemple un 68070, avec sa mémoire de programme (MP), qui commande un contrôleur graphique (CT.GRAPH) connecté à une DRAM, par exemple une MN 41257 de chez Matsushita, et à un écran de visualisation graphique (CRT).

La DRAM, par exemple de 256 Kbits avec 32 boîtiers en parallèle, est connectée au moyen d'un bus de données de 32 bits, d'un bus d'adresse de 9 bits et d'un ensemble de connexions de contrôle (CTRL) pour recevoir notamment des séquences de signaux de contrôle de colonne (CAS) et de contrôle de ligne (RAS); il est connu que certaines séquences de ces signaux permettent des accès en lecture à grand débit à la DRAM; la dimension des bus indiquée ci-dessus n'est évidemment pas limitative.

Le contrôleur graphique (CT.GRAPH) comporte un processeur d'affichage (DCLP) associé à un générateur de synchronisation (SYN) pour contrôler l'écran (CRT); du fait que le débit de la DRAM est supérieur au débit de la visualisation, les pixels lus dans la DRAM sont temporairement mémorisés dans une FIFO contenue dans le DCLP; lorsque la FIFO est pleine elle émet un signal de remplissage (BUSY) pour demander momentanément l'arrêt de la lecture des pixels.

Le contrôleur graphique comporte un processeur graphique (MCLP), et un interface système (INT) pour communiquer avec le microprocesseur de commande.

Il est connu que des demandes d'accès à la DRAM sont formulées par les trois processeurs du

3

système à savoir : par le microprocesseur de commande (P), par le processeur graphique (MCLP) et par le processeur d'affichage (DCLP).

Pour gérer ces demandes d'accès, qui peuvent être simultanées, le contrôleur graphique selon l'invention comporte d'une part un arbitre de bus interne (BUSAR) et d'autre part un contrôleur de DRAM (CT.DRAM).

Selon l'invention une distinction est faite entre deux types de demandes d'accès formulées par le DCLP : d'une part les demandes d'accès à un seul mot (REQ3), d'autre part les demandes d'accès en rafale (RAF) à plusieurs mots; les demandes en rafale sont exclusivement des demandes de lecture de pixels pour alimenter avec un fort débit la FIFO du DCLP.

Cette distinction a pour but de permettre une gestion différente de la priorité de ces deux demandes d'accès ainsi que ci-après décrit.

Sur la figure 1 sont aussi représentées symboliquement les connexions prévues pour transmettre les demandes d'accès à un seul mot de la DRAM en provenance soit du microprocesseur de commande (REQ1), soit du processeur graphique (REQ2), soit du processeur d'affichage (REQ3); ces demandes font l'objet d'un traitement de pré-sélection dans l'arbitre de bus interne (BUSAR), le résultat de cette pré-sélection est la sélection d'une seule demande sélectionnée (REQS) laquelle est transmise au contrôleur de DRAM (CT.DRAM).

Le contrôleur de DRAM reçoit de plus d'une part des demandes de rafraîchissement (REQFR) en provenance du DCLP, et d'autre part des demandes d'accès en rafale (RAF) en provenance du DCLP; il effectue l'arbitrage entre ces trois demandes.

Le fonctionnement connu d'un écran CRT se décompose, cycliquement, en une période de retour trame et en plusieurs périodes de balayage dont le nombre dépend du nombre de lignes de l'écran; chaque période de balayage (de l'ordre de 64 μsec) comporte une étape d'affichage des pixels sur l'écran (de l'ordre de 45 μsec) et une étape de retour ligne.

Le système selon l'invention permet d'affecter aux demandes d'accès des priorités différentes en fonction de ces périodes et/ou étapes.

Pendant l'étape d'affichage, la plus grande priorité est donnée aux accès DRAM qui alimentent la FIFO du DCLP; chacun de ces accès comporte d'abord une phase préparatoire puis une phase de lecture effective des pixels; dans la pratique, tous les accès à un seul mot (REQ3) sont des accès préparatoires, et tous les accès en rafale (RAF) sont des lectures effectives de pixels; de ce fait, si la lecture préparatoire a été effectuée, la priorité est donnée à la lecture en rafale (RAF), sinon la priorité est donnée à la lecture préparatoire (REQ3); il arrive que la lecture en rafale ne peut pas s'accomplir complètement sans interruption, c'est le cas lorsque la FIFO est pleine (BUSY); dans ce cas d'interruption, l'arbitre de bus donne la priorité à une lecture préparatoire éven-tuelle en attente (REQ3); en son absence ( $\overline{REQ3}$ ), une lecture demandée par le microprocesseur de commande (REQ1) peut être satisfaite mais dès que la FIFO commence à se vider, du fait de l'affichage, la lecture en rafale interrompue est prioritairement poursuivie.

Pendant l'étape de retour ligne, différentes priorités sont encore affectées: premièrement rafraîchissement de la DRAM, deuxièmement remplissage de la FIFO pour préparer l'affichage de la ligne suivante, troisièmement satisfaction des accès demandés par le MCLP (REQ2), puis des accès demandés par le microprocesseur (REQ1).

Selon un mode préféré, le rafraîchissement de la DRAM s'effectue le plus tôt possible c'est à dire dès que la lecture du dernier pixel de la ligne est effectuée; le DCLP détecte ce moment et ainsi le rafraîchissement peut commencer un peu avant le retour ligne proprement dit; de ce fait le rafraîchissement commence à une date mobile et non pas, comme il est connu de le faire, à une date fixe qui serait par exemple le début du retour ligne; dans ce but, le DCLP formule la demande de rafraîchissement (REQFR) dès que la dernière lecture en rafale pour une ligne est terminée.

Le nombre de lignes à rafraîchir à chaque fois dépend de la taille mémoire de la DRAM pour que la DRAM soit entièrement rafraîchie en temps utile, c'est à dire par exemple toutes les 4 msec; en rafraîchissant 6 lignes de DRAM à chaque fois, on peut ainsi rafraîchir (4000μsec:64μsec)x6 lignes c'est à dire 375 lignes toutes les 4 msec ce qui est amplement suffisant; pour la DRAM indiquée ci-dessus, chaque rafraîchissement s'effectue, par exemple, en 2 μsec; après la période de rafraîchissement, il y a lieu, dans un premier temps d'initialiser l'accès aux pixels de la ligne suivante jusqu'à remplissage de la FIFO, puis de satisfaire les éventuelles demandes d'accès en attente au niveau de l'interface du bus interne; à ce moment, par ordre de priorité décroissante, seuls les accès MCLP (REQ2) et les accès microprocesseur (REQ1) sont pris en compte.

Pendant la période de retour trame, les rafraîchissements s'effectuent prioritairement, et périodiquement, à date fixe; le reste du temps est affecté d'abord aux demandes MCLP (REQ2) puis aux demandes microprocesseur (REQ1).

Les demandes d'accès à un seul mot, c'est à dire REQ1, REQ2 et REQ3, sont arbitrées par un arbitre de bus (BUSAR) constitué d'un système de portes logiques combinatoires.

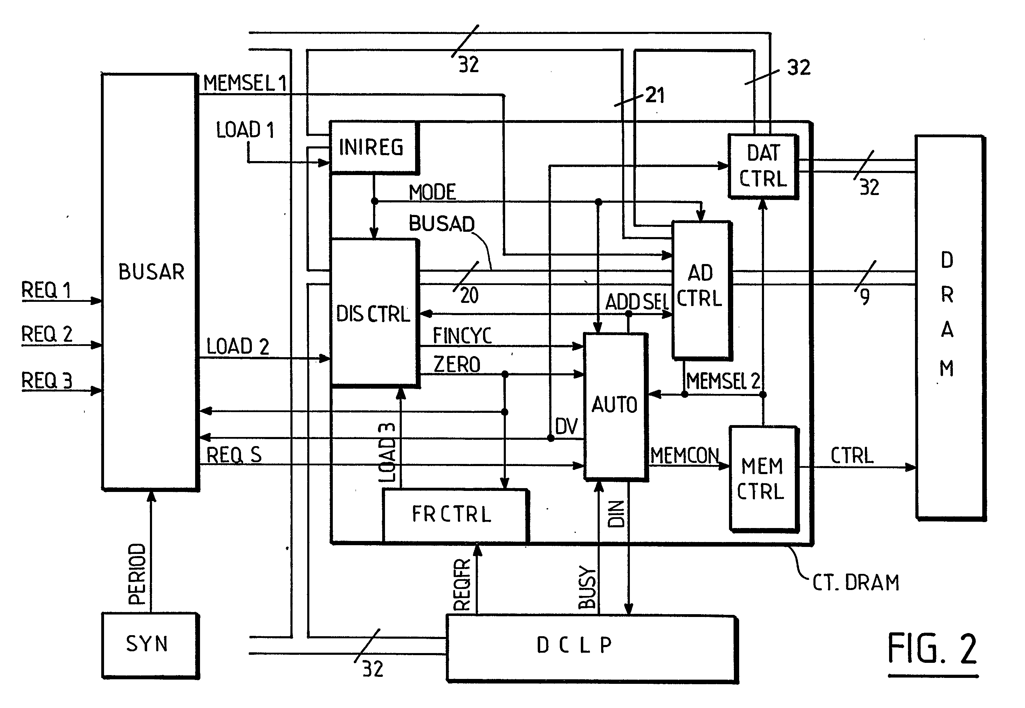

la figure 2 représente essentiellement l'architecture du contrôleur de DRAM (CT.DRAM).

Il est conçu de telle sorte qu'il peut être implanté sur une seule puce pour être vendu séparément avec toutes ses fonctionnalités; celles-ci le rendent "tout usage" c'est à dire utilisable dans n'importe quel système graphique avec n'importe quelle DRAM et surtout avec différents modes d'organisations de DRAM : mode 4 bits (nibble), mode page sans ou avec entrelacement (interleaving).

Le contrôleur de DRAM (CT.DRAM) comporte :

A) un registre d'initialisation (INIREG). Ce registre mémorise les paramètres spécifiques à la DRAM choisie et à son mode d'organisation par exemple : rafraîchissement de 4 ou de 6 pages à la fois, organisation en mode 4 bits ou en mode page et, dans ce cas, avec ou sans entrelacement, dimension de chaque banc mémoire; le registre d'initialisation peut, par exemple, comporter 6 bits :
- 1 bit pour indiquer le nombre, 4 ou 6, de pages à rafraîchir
- 3 bits pour banc mémoire de 64K, ou 256K, ou 1M.
- 1 bit pour le mode 4 bit, ou non.
- 1 bit pour le mode entrelacement, ou non.

les paramètres spécifiques sont initialement positionnés par le microordinateur de commande via une commande de chargement LOAD1; pendant le fonctionnement ces informations sont disponibles sur la(les) connexion(s) MODE comme ci-après décrit.

B) un module contrôleur de rafraîchissement (FRCTRL). Ce module reçoit du DCLP l'ordre du départ d'un cycle de rafraîchissement (REQFR) comme susdit; dans ce cas ce module transmet, par la connexion LOAD3, la prochaine adresse à rafraîchir laquelle a été préalablement mémorisée et indexée cycliquement; ce module transmet aussi une demande de rafraîchissement (REFRESH non représentée) à d'autres modules parmi lesquels notamment un automate ci-après décrit; le nombre de pages à rafraîchir est chargé dans un compteur lequel est décrémenté au fur et à mesure jusqu'à indiquer que le rafraîchissement est terminé, dans ce cas le contrôleur de rafraîchissement mémorise l'adresse ainsi indexée comme susdit en vue du prochain cycle.

C) un module de contrôle de la lecture en rafale (DIS CTRL). Ce module reçoit en entrée les données disponibles sur le bus interne de 32 bits; ces données sont l'adresse du prochain mot à lire en rafale, sur 20 bits, et le nombre de mots à lire, sur 8 bits; la commande LOAD2 qu'il reçoit permet de prendre en compte ces données; c'est le chargement de ces données qui constitue la demande d'accès en rafale (RAF) susdite; en sortie, ce module positionne un signal ZERO qui indique s'il reste, ou non, des mots à lire, dans ce but, ce module comporte un compteur décrémenteur du nombre de mots à lire; ce compteur est initialisé avec la commande LOAD2 et est décrémenté lors de chaque lecture d'un mot dans la DRAM; il peut arriver qu'une lecture en rafale comporte des mots situés sur plusieurs pages ou que, dans le cas du mode 4 bits, la rafale comporte des mots situés dans plusieurs groupes de 4 mots; cette situation est détectée par le module et un signal (FINCYC) est positionné en sortie du module à destination de l'automate ci-après décrit afin que ce dernier en tienne compte pour repositionner les signaux RAS et CAS; en sortie, le module au moyen d'un incrémenteur d'adresse délivre l'adresse en cours de lecture en rafale sur un bus d'adresses de 20 bits.

Il est remarquable que, compte tenu des priorités imparties aux accès DRAM telles qu'indiquées ci-dessus, il est possible d'utiliser le même incrémenteur d'adresse et le même compteur décrémenteur du nombre de mots aussi bien pour les lectures en rafale que pour les rafraîchissements.

Pour la même raison, le même signal ZERO indique s'il bascule à '1' (c'est à dire compteur = 0) soit la fin d'une lecture en rafale soit la fin d'un rafraîchissement, inversement s'il bascule à '0' (c'est à dire compteur≠0) il indique qu'il y a à satisfaire soit une lecture en rafale, soit un rafraîchissement; de plus, le même bus est utilisé pour transmettre l'adresse soit de lecture en rafale soit de rafraîchissement.

D) un module de contrôle d'adressage (AD.CTRL). Ce module reçoit d'une part l'adresse émise par le module (DIS CTRL), d'autre part l'adresse présente sur le bus interne de 21 bits correspondant à une éventuelle demande pré-sélectionnée d'accès à un seul mot (REQS); l'indication du bon choix à faire entre ces deux adresses provient de l'automate ci-après décrit par la commande ADDSEL; l'adresse élue en conséquence de ce choix est positionnée en sortie sur le bus d'adresse de la DRAM.

Ce module de contrôle d'adressage reçoit aussi en entrée les signaux de MODE susdits et, en conséquence, émet, en sortie, les signaux adéquats de sélection mémoire MEMSEL2.

E) un module de contrôle de mémoire (MEM CTRL). Ce module effectue une simple sélection à partir des signaux de commande qu'il reçoit pour sélectionner les zones mémoires accédées (banc, mot, demi-mot, octet); pour ne pas surcharger la description, il ne sera pas plus amplement décrit.

F) un module de contrôle de données (DAT CTRL) pour sélectionner la direction du transfert de données (lecture, écriture) et multiplexer les données sur le bus.

G) un automate d'une part d'arbitrage pour arbitrer entre les demandes d'accès, d'autre part de génération pour générer des séquences de signaux de contrôle de la DRAM via le module MEM CTRL.

L'automate (AUTO) reçoit principalement les signaux, actifs avec la valeur 1, déjà mentionnés :
- REFRESH : signal en provenance du module FRCTRL susdit indiquant qu'il y a, ou non, un cycle de rafraîchissement à exécuter (non représenté).
- ZERO : signal susdit.
- FINCYC : signal susdit.
- CASSEL : signal de sélection d'adresse paire/impaire valable uniquement dans le mode entrelacé (non représenté)
- BUSY : signal indiquant, ou non, que la FIFO du DCLP est pleine
- WRITREQ/READREQ : signaux indiquant, ou non, qu'il y a une demande d'accès pré-sélectionnée à un seul mot (REQS) en provenance de l'arbitre de bus. (écriture ou lecture selon le cas). ·
- MODE : signaux significatifs du mode d'organisation de la DRAM déjà mentionnés ci-dessus, par exemple INTER = 1 pour le mode entrelacé et NIBBLE = 1 pour le mode 4 bits.

La première tâche de l'automate est d'arbitrer les demandes selon les priorités susdites, et ainsi élire une demande à exécuter; dans l'automate, les demandes de lecture en rafale (RAF) et les demandes de rafraîchissement (REFRESH) peuvent avoir la même priorité, qui est aussi la plus forte, puisque ces demandes ne peuvent jamais être en concurrence comme susdit.

La deuxième tâche de l'automate est de générer les signaux correspondant à cette demande élue.

Les signaux générés en sortie sont principalement :
- MEMCON : Contrôle de mémoire, notamment :

| | |
|---|---|
| -RAS : | positionnement de l'adressage de rangée |
| -CAS : | positionnement de l'adressage de colonne; il y a deux signaux CAS1 et CAS2 dans le cas d'entrelacement |
| -WR : | signal d'écriture (dans le cas d'accès à un seul mot) |

- ADDSEL : signal de choix de l'adresse correspondant à la demande à exécuter pour provoquer le verrouillage (Latch) de l'adresse
- DV : signal de validation des données lues dans le cas d'accès à un seul mot
- DIN : signal de validation de chaque donnée lue dans le cas d'accès en rafale.

Un automate est un dispositif connu comportant différents états en nombre fini, chaque coup d'horloge provoquant le passage de l'automate d'un état à un autre; le séquencement des états est conditionné par l'évolution des signaux d'entrée et des signaux de sortie; souvent, et c'est le cas ici, certains signaux de sortie sont dédiés au fonctionnement de l'automate et servent ainsi exclusivement comme entrées de l'automate pour conditionner le séquencement des états.

Dans le cas présent, l'exécution de chaque demande d'accès élue correspond à une succession de combinaisons de signaux de sorties dont certaines sont identiques d'une demande à l'autre; les diverses combinaisons possibles des signaux de sorties peuvent alors être recensées, et un numéro d'état est attribué à chacune d'elles.

Les tableaux fournis en annexe indiquent :
- Tableau A : Tableau des 21 états possibles de l'automate et des signaux de sortie correspondant.
- Tableau B : Liste des conditions de passage d'un état à l'autre, ce tableau comporte 4 pages.

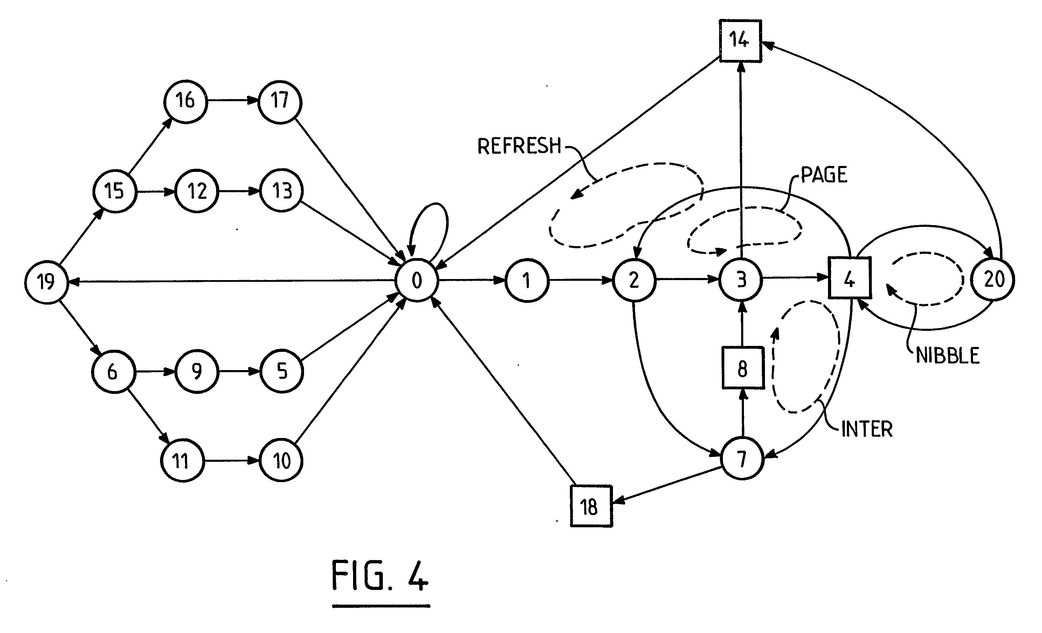

Le diagramme des séquencements possibles des états de l'automate est représenté sur la figure 4.

Les signaux de sorties rebouclés en entrée comportent 5 fils ce qui convient pour transmettre les 21 numéros d'états possibles.

Dans le tableau A, les 21 états sont numérotés de 0 à 20; pour chaque état les signaux de sortie positionnés à '1' sont indiqués, les signaux positionnés à '0' ont été laissés en blanc pour ne pas alourdir le tableau, sauf pour l'état 0.

La signification des signaux de sortie est la suivante selon qu'ils sont positionnés ou non :
- Signaux actifs à la valeur '0':

6

RAS : Validation de l'adresse ligne
CAS 1 : Validation de l'adresse colonne
CAS 2 : Validation de l'adresse colonne (cas d'entrelacement)
- Signaux actifs à la valeur '1':
DV: Validation de donnée lue, accès à un seul mot
WR: Validation de l'écriture en mémoire
RESW: Accusé de réception d'écriture
MUX : Sélection d'adresse ligne/colonne
ADD : Verrouillage d'adresse de lecture en rafale, ou de rafraîchissement; ce signal permet l'incrémentation et la décrémentation des compteurs du module DISCTRL comme susdit.
ADDM: Verrouillage d'adresse de lecture à un seul mot DIN : Validation de donnée lue, accès en rafale.

Dans le tableau B les conditions de passage d'un état à un autre sont représentées en langage booléen pour déterminer, en fonction des variables d'entrée, dans quel état doit aller l'automate.

Les variables d'entrée sont :

WRITREQ : demande d'écriture d'un seul mot (voir REQS susdit)
READREQ : demande de lecture d'un seul mot (voir REQS susdit)
ZERO: fin d'une lecture en rafale ou de rafraîchissement
BUSY: FIFO pleine
REFRESH : cycle de rafraîchissement à exécuter
FP: fin d'une page mémoire (voir FINCYC susdit)
INTER : mode entrelacé
NIBBLE: mode 4 bits
ZERONIB : fin d'un cycle 4 bits (voir FINCYC susdit)
CASSEL: sélection d'adresse paire/impaire (utile en mode entrelacé)

Dans le tableau, il y a une formule booléenne pour chaque état, chaque formule étant applicable lorsque ('SI') le signal d'horloge (PHI(2)) se produit d'où la condition permanente :

'SI' PHI(2) 'ALORS'

Les conditionnements parlent d'eux-mêmes mais, pour éviter toute confusion, la première condition de l'état '0' va être détaillée :

'SI' -REFRESH. -WRITREQ. -READREQ. (ZERO + BUSY)
'ALORS' 'ALLERA' ETAT0

cette condition signifie :

Si il n'y a ,     ('SI')

a) ni demande de rafraîchissement,     (-REFRESH)
b) ni demande d'écriture d'un seul mot     (-WRITREQ)
c) ni demande de lecture d'un seul mot     (-READREQ)
d) ni de demande de lecture en rafale     (ZERO + ...)
e) ou bien si la FIFO du DCLP est pleine(... + BUSY)

(dans le cas d'une demande de lecture en rafale, c'est à dire -ZERO)
alors aller à l'état '0'.     ('ALORS' 'ALLERA' ETAT0) Ceci revient à dire à l'automate que s'il n'y a rien à faire (a,b,c,d) ou si il est impossible de faire ce qui est demandé (e), l'automate doit rester dans l'état '0', c'est à dire dans l'attente d'une demande exécutable.

Bien entendu l'écriture (-READREQ) est équivalente à l'écriture ( $\overline{\text{READREQ}}$ ).

Les conditionnements des autres états ne sont que la formulation booléenne de ce qui a été dit ci-dessus.

L'automate est ainsi parfaitement défini par les indications fournies par les tableaux A et B.

Les tableaux A et B peuvent être pris en combinaison pour construire la figure 4 qui est le diagramme des états successifs de l'automate.

Sur ce diagramme il est clair qu'il y a deux parties principales; sur la partie de gauche c'est à dire Etat 0 puis Etat 19, etc... les accès à un seul mot (REQS) sont traités :
- les états 15-12-13 traitent la lecture d'un mot d'adresse impaire en entrelacement
- les états 15.16.$\overline{17}$ traitent toutes les autres lectures
en lecture, la donnée lue est validée (DV=1, cf. tableau A) soit dans l'état 13, soit dans l'état 17.
les états 6.9.5. traitent l'écriture d'un mot d'adresse impaire en entrelacement
- les états 6.11.10 traitent toutes les autres écritures.
en écriture, le signal WR reste positionné pendant deux coups d'horloge (soit 6+9, soit 6+11) conformément au tableau A.

Sur ce diagramme, un accès à un seul mot (REQS) ne dure que 5 cycles d'horloge et qu'il n'est jamais interrompu.

Sur la partie droite, les rafraîchissements et les accès en rafale sont traités en faisant ressortir le mode de fonctionnement :

Les états de forme carrée sont les états où le signal DIN est positionné, c'est à dire qu'une donnée est à ce moment disponible sur le bus.

Les autres états, de forme ronde, sont des états de préparation des signaux nécessaires à l'opération en cours.

Un cycle de rafraîchissement passe par les états 1, 2, 3, 14, 0 comme indiqué avec les tirets.

C'est dans l'état 1 que le signal ADD est positionné à destination du module DISCTRL comme susdit.

Pour les lectures en rafale, on remarque que, l'état 4, dans lequel le signal DIN est positionné, est un passage obligé dont on sort vers des états différents suivant l'organisation de la DRAM, soit respectivement :

- état 20 en mode 4 bits (condition 'SI' NIBBLE de l'état 4 du tableau B1)
- état 7 en entrelacement (condition 'SI' INTER du tableau B1)
- état 2 en mode page (condition 'SI' -INTER.-NIBBLE)

Dans le mode 4 bits, une séquence normale de lecture passe successivement par les états :

0, 1, 2, 3, 4, 20, 4, 20, 4, 20, 14, 0

L'état 4 et l'état 14 sont soulignés pour bien montrer que l'on passe normalement 4 fois par le signal DIN positionné avant de détecter la condition ZERONIB.

Ce simple cycle de lecture peut être perturbé comme susdit (voir FINCYC, BUSY,...), l'évènement étant alors pris en compte dans l'état 20, ou dans l'état 3, et dans ces deux cas on va à l'état 14, avant de revenir à l'état 0.

Dans le mode page, une séquence simple de lecture passe successivement par les états :

0, 1, 2, 3, 4, 2, 3, 4,...,2, 3, 14, 0.

La sous-séquence 2, 3, 4, se répète autant de fois qu'il y a de mots à lire, pour autant qu'aucune perturbation ne se produise; dans le cas contraire, la prise en compte s'effectue dans l'état 3.

Dans le mode avec entrelacement, la boucle de lecture passe successivement par les états :

[3, 4 (adresse paire), 7, 8 (adresse impaire)]; pour rentrer dans la boucle, la séquence commence par les états 0, 1, 2 puis, selon que la première adresse à lire est paire ou impaire, on rentre dans la boucle soit par l'état 3, soit par l'état 7, respectivement; la boucle de lecture prend en compte les évènements perturbateurs soit dans l'état 3, soit dans l'état 7.

D'une manière générale, en cas de perturbation d'un cycle de lecture en rafale, une lecture, soit dans l'état 14, soit dans l'état 18, est toujours effectuée avant le retour à l'état d'attente; ceci implique que les conditions de perturbation (telles que 'fin de page', 'fin de cycle', 'FIFO pleine') doivent être détectées à temps de telle sorte que cette dernière lecture puisse s'effectuer.

L'automate ainsi décrit est avantageusement réalisé sous forme d'un réseau programmable, ci-après PLA; la conception et l'implantation d'une PLA sur une puce de silicium à partir des tableaux A et B est réalisable directement au moyen de logiciels automatiques.

Le choix des entrées, des sorties, et des conditionnements (tableau B) influe sur la surface de puce occupée par la PLA; les choix effectués ici ont abouti à une PLA optimisée; il est à remarquer que cette optimisation n'empêche pas que certains états sont identiques du point de vue des signaux de sortie positionnés (dans le tableau A : 7 = 12, 3 = 16, 2 = 15 = 20) mais ces états identiques ne s'insèrent pas dans des séquences identiques; d'autres possibilité sont envisageables sans sortir du cadre de la présente invention.

Sur la figure 2, l'arbitre de BUS (BUSAR) est représenté, il reçoit les signaux susdits REQ1, REQ2, REQ3 et il émet, notamment, les signaux de sélection de mémoire (MEMSEL1) résultant de l'arbitrage effectué à destination du module de contrôle d'adresse (AD CTRL); le signal REQS significatif de la requête pré-sélectionnée comme susdit est, dans le mode de réalisation ici décrit, composé de deux signaux comme sus-mentionné : READ REQ et WRIT REQ; les priorités d'arbitrage dépendent, comme susdit, de la période en cours (trame, affichage, retour ligne,...), à cet effet l'arbitre de bus (BUSAR) reçoit du module de synchronisation (SYN) des signaux (PERIOD) significatifs de la période en cours.

Le tableau C représente les différentes priorités de l'arbitre de bus (BUSAR); après avoir rappelé que ces priorités ne concernent que les accès à un seul mot, puisque les autres accès sont arbitrés par l'automate, on peut expliciter les conditions d'arbitrage de chaque colonne du tableau C comme suit :

- Pendant le retour trame (RTRAM) :

Colonne 1 : Priorité MCLP puis P.

- En dehors du retour trame ( $\overline{\text{RTRAM}}$ ) : Pendant le retour ligne (RLIG)

Colonne 2 :

Si 'ZERO' c'est à dire à la fin du rafraîchissement, priorité exclusive au DCLP pour préparer l'accès en rafale aux pixels de la ligne suivante. Colonne 3 :

Si ' $\overline{Zero}$ ' c'est à dire qu'il y a une lecture en rafale en cours ( $\overline{BUSY}$ ), ou en attente (BUSY), priorité au MCLP puis à P.

En dehors du retour ligne ( $\overline{RLIG}$ ), c'est à dire pendant la période d'affichage Colonne 4 :

Si 'ZERO', c'est à dire qu'il n'y a pas d'accès en rafale en cours, alors, priorité exclusive au DCLP pour préparer le prochain accès en rafale. Colonne 5 :

Si ' $\overline{ZERO}$ ', c'est à dire qu'il y a un accès en rafale en cours (et donc qu'un 'BUSY' peut se produire) alors priorité au DCLP puis à P.

Le tableau C met ainsi en évidence un autre avantage résultant du fait que le même compteur de mots est utilisé pour les accès en rafale et pour les rafraîchissements; en effet le même signal ZERO, avec des significations fonctionnelles différentes, est utilisé pour des priorités identiques dans les colonnes 2 et 4; de ce fait le système de portes logiques dont est constitué l'arbitre de bus est extrêmement simple, compact et facile à réaliser.

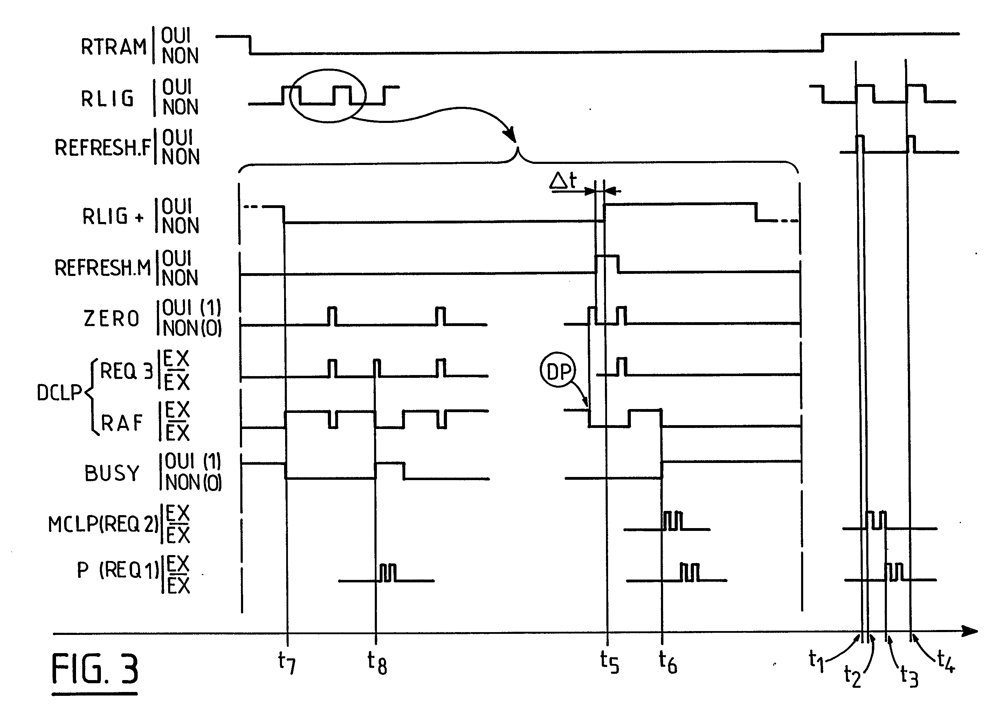

La figure 3 représente le diagramme de certains signaux et actions.

Les signaux significatifs du retour trame (RTRAM) et du retour ligne (RLIG) sont représentés.

Pendant le retour trame, (en haut à droite de la figure 3) les rafraîchissements se font à date fixe , (REFRESH.F) à chaque montée du signal RLIG; par exemple à la date t1, un rafraîchissement est commencé, il se termine à la date t2; à ce moment, et jusqu'à la date t4, l'arbitre de bus donne la priorité aux accès MCLP (REQ2) puis, par exemple à la date t3, aux accès microprocesseur (REQ1).

En dehors du retour trame, la figure a été agrandie pour mieux montrer (RLIG +) les étapes d'affichage et de retour ligne pour une seule ligne ce qui est suffisant pour la description de l'invention.

Avant le retour ligne qui se produit à la date t5, le dernier pixel de la ligne en cours a été lu comme indiqué par la flèche DP qui pointe sur l'exécution (EX) d'une lecture en rafale (RAF); à ce moment le signal ZERO passe à 1 et, comme susdit, le DCLP génère une demande de rafraîchissement à date mobile (REFRESH.M) dont l'exécution commence avant ($\Delta$t) le signal de retour ligne qui bascule à la date fixe t5.

Pendant que dure le rafraîchissement le signal ZERO émis par le compteur-de-mots-à-rafraîchir est à '0' car le compteur lui-même n'est pas à '0'; à la fin du rafraîchissement, le signal ZERO bascule et maintenant l'on se trouve dans le cas de la colonne 2 du tableau C, c'est à dire qu'il y a lieu de préparer l'affichage de la ligne suivante au moyen d'un accès préparatoire DCLP (REQ3) suivi d'un (ou plusieurs) accès en rafale (RAF) qui, à ce moment, ne peut être interrompu que par le remplissage de la FIFO ce qui se traduit par la montée du signal BUSY (date t6): maintenant, comme indiqué à la colonne 3 du tableau C, des accès MCLP (REQ2) puis microprocesseur (REQ1) peuvent s'exécuter.

A la date fixe t7 commence l'affichage d'une ligne, lequel affichage a, en principe, été préparé comme susdit; l'affichage sur l'écran CRT provoque la descente du signal BUSY et l'exécution de l'accès en rafale reprend jusqu'à ce que cet accès soit terminé ce qui se traduit par la montée du signal ZERO significatif du compteur-de-mots-à-lire; cette montée du signal ZERO provoque l'exécution d'un accès REQ3 préparatoire de la rafale suivante et ainsi de suite jusqu'à la fin de la ligne.

Il peut arriver, date t8, qu'une lecture en rafale soit interrompue par le signal BUSY, à ce moment un accès REQ3 puis des accès microprocesseur (REQ1) peuvent être exécutés (voir colonne 5 du tableau C) jusqu'à ce que le signal BUSY retombe et permette alors la reprise de la lecture en rafale interrompue.

## TABLEAU A

des 21 états avec leurs sorties.

| Etats | 0 | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|---|
| RAS | 1 | 1 | | | | | | | | | | | | | | | | | | 1 | |
| CAS1 | 1 | 1 | 1 | | | 1 | 1 | 1 | 1 | 1 | | | 1 | 1 | | 1 | | | 1 | 1 | 1 |
| CAS2 | 1 | 1 | 1 | 1 | 1 | | 1 | | | | 1 | 1 | | | 1 | 1 | 1 | 1 | | 1 | 1 |
| DV | O | | | | | | | | | | | | | 1 | | | | 1 | | | |
| WR | O | | | | | | 1 | | 1 | | | 1 | | | | | | | | | |
| RESW | O | | | | 1 | | | | | 1 | | | | | | | | | | | |
| MUX | O | 1 | | | | | | | | | | | | | | | | | | 1 | |
| ADD | O | 1 | | | 1 | | | | 1 | | | | | | | | | | | | |
| ADDM | O | | | | | | | | | | | | | | | | | | | 1 | |
| DIN | O | | | 1 | | | | 1 | | | | | | | 1 | | | | 1 | | |

TABLEAU B   (4 pages)

```
ETATO  :              'SI' PHI(2) 'ALORS' (
      'SI'  -REFRESH.-WRITREQ.-READREQ.(ZERO+BUSY)
           'ALORS'  'ALLERA' ETATO
      'SI'  -ZERO.-BUSY+REFRESH
           'ALORS'  'ALLERA' ETAT1
      'SI'  -REFRESH.(WRITREQ+READREQ).(ZERO+BUSY)
           'ALORS'  'ALLERA' ETAT19      )
```

```
ETAT1  :              'SI' PHI(2) 'ALORS'
                      'ALLERA' ETAT2
```

```
ETAT2  :              'SI' PHI(2) 'ALORS' (
      'SI'  INTER.CASSEL
           'ALORS'  'ALLERA' ETAT7
      'SI'  -(INTER.CASSEL)
           'ALORS'  'ALLERA' ETAT3        )
```

```
ETAT3  :              'SI' PHI(2) 'ALORS' (
      'SI'  -ZERO.-BUSY.-REFRESH.-(NIBBLE.ZERONIB).(NIBBLE+-FP)
           'ALORS'  'ALLERA' ETAT4
      'SI'  ZERO+BUSY+REFRESH+NIBBLE.ZERONIB+(-NIBBLE).FP
           'ALORS'  'ALLERA' ETAT14       )
```

```
ETAT4    :           'SI' PHI(2) 'ALORS' (
         'SI'  -INTER.-NIBBLE
             'ALORS'  'ALLERA' ETAT2
         'SI'  NIBBLE
             'ALORS'  'ALLERA' ETAT20
         'SI'  INTER
             'ALORS'  'ALLERA' ETAT7    )



ETAT5    :           'SI' PHI(2) 'ALORS'
                      'ALLERA' ETAT0



ETAT6    :           'SI' PHI(2) 'ALORS' (
         'SI'  INTER.CASSEL
             'ALORS'  'ALLERA' ETAT9
         'SI'  -(INTER.CASSEL)
             'ALORS'  'ALLERA' ETAT11   )



ETAT7    :           'SI' PHI(2) 'ALORS' (
         'SI'  -ZERO.-BUSY.-REFRESH.-FP
             'ALORS'  'ALLERA' ETAT8
         'SI'  ZERO+BUSY+REFRESH+FP
             'ALORS'  'ALLERA' ETAT18   )



ETAT8    :           'SI' PHI(2) 'ALORS'
                      'ALLERA' ETAT3
```

```
ETAT9     :          'SI' PHI(2) 'ALORS'
                     'ALLERA' ETAT5


ETAT10    :          'SI' PHI(2) 'ALORS'
                     'ALLERA' ETATO


ETAT11    :          'SI' PHI(2) 'ALORS'
                     'ALLERA' ETAT10


ETAT12    :           'SI' PHI(2) 'ALORS'
                      'ALLERA' ETAT13


ETAT13    :           'SI' PHI(2) 'ALORS'
                      'ALLERA' ETATO


ETAT14    :           'SI' PHI(2) 'ALORS'
                      'ALLERA' ETATO


ETAT15    :              'SI' PHI(2) 'ALORS' (
          'SI'  INTER.CASSEL
                'ALORS'  'ALLERA' ETAT12
          'SI'  -(INTER.CASSEL)
                'ALORS'  'ALLERA' ETAT16    )
```

```
ETAT16      :              'SI' PHI(2) 'ALORS'
                           'ALLERA' ETAT17



ETAT17      :              'SI' PHI(2) 'ALORS'
                           'ALLERA' ETAT0



ETAT18      :              'SI' PHI(2) 'ALORS'
                           'ALLERA' ETAT0



ETAT19      :                  'SI' PHI(2) 'ALORS' (
            'SI' .WRITREQ
                'ALORS'  'ALLERA' ETAT6
            'SI' -WRITREQ
                'ALORS'  'ALLERA' ETAT15      )



ETAT20      :                  'SI' PHI(2) 'ALORS' (
            'SI' -ZERO.-BUSY.-ZERONIB
                'ALORS'  'ALLERA' ETAT4
            'SI'  ZERO+BUSY+ZERONIB
                'ALORS'  'ALLERA' ETAT14      )
```

14

## TABLEAU C

| Conditions | RTRAM | R̅T̅R̅A̅M̅ | | | |
| --- | --- | --- | --- | --- | --- |
| | | RLIG | | R̅L̅I̅G̅ | |
| | | ZERO | Z̅E̅R̅O̅ | ZERO | Z̅E̅R̅O̅ |
| Priorités (BUSAR) | 1) MCLP (REQ2) 2)P(REQ1) | DCLP (REQ3) | 1) MCLP (REQ2) 2)P(REQ1) | DCLP (REQ3) | 1) DCLP (REQ3) 2)P(REQ1) |
| N° de colonne | 1 | 2 | 3 | 4 | 5 |

## Revendications

1. Système graphique comportant, connectés entre eux par bus de données, commande et adresse, un micro-ordinateur de commande à mémoire de programme pour commander le système, un écran de visualisation graphique, une mémoire vive dynamique (ci-après DRAM) pour mémoriser des mots d'information d'affichage et un contrôleur graphique comprenant :
- un processeur graphique (MCLP)
- un processeur d'écran (DCLP), associé à un générateur de synchronisation, pour, en se synchronisant avec le balayage de chaque ligne de l'écran, lire les mots d'information à afficher,
- un interface micro-ordinateur,
- un contrôleur de DRAM,
le dit contrôleur de DRAM comportant des moyens de génération pour générer, selon chaque demande d'accès, des séquences de signaux de contrôle, notamment contrôle de ligne (RAS) et contrôle de colonne (CAS), de la DRAM, chaque demande pouvant être soit une demande de rafraîchissement en provenance du dit processeur d'écran (DCLP), soit une demande de lecture des informations d'une fenêtre en provenance du dit processeur d'écran (DCLP), soit encore une demande d'accès à un seul mot (REQ1, REQ2) en provenance du processeur graphique (MCLP) ou en provenance du micro-ordinateur de commande via le dit interface, et des moyens d'arbitrage pour arbitrer les dites demandes lesquelles peuvent être simultanées alors que leurs exécutions ne sauraient l'être, caractérisé en ce que chaque dite demande de lecture des informations d'une fenêtre est décomposée en d'une part au moins une demande d'accès à un seul mot (REQ3) pour lire la description de la dite fenêtre, et d'autre part une demande de lecture en rafale (RAF) de plusieurs mots pour lire les pixels de la dite fenêtre, et en ce que les dits moyens d'arbitrage, comportent des premiers moyens d'arbitrage (BUSAR), ci-après interface de bus interne, pour effectuer une pré-sélection entre les dites demandes d'accès à un seul mot (REQ1, REQ2, REQ3) et ainsi sélectionner l'une d'elles (REQS), et des deuxièmes moyens d'arbitrage (AUTO) pour arbitrer entre la dite demande pré-sélectionnée (REQS), une demande de rafraîchissement (REQFR) et une demande de lecture en rafale (RAF), et ainsi élire une demande élue à exécuter, et en ce que les dits deuxièmes moyens d'arbitrage et les dits moyens de génération sont confondus dans un même module (AUTO) comportant un automate à nombre d'états fini.

2. Système graphique selon la revendication 1 caractérisé en ce que le dit processeur d'écran (DCLP) est pourvu de moyens pour détecter que tous les pixels de la dernière fenêtre d'une ligne d'écran ont été lus dans la DRAM, et, dans ce cas, générer immédiatement, c'est à dire sans attendre une date fixe de fin d'affichage, une demande de rafraîchissement.

3. Système graphique selon la revendication 2 comportant des moyens pour gérer l'exécution des accès en rafale (DISCTRL, ZERO,...) caractérisé en ce que les mêmes moyens sont aussi utilisés pour gérer l'exécution des rafraîchissements.

4. Système graphique selon la revendication 3 caractérisé en ce que les dits premiers moyens d'arbitrage entre les demandes d'accès à un seul mot sont agencés pour permettre des priorités de pré-sélection différentes selon que le système se trouve en période d'affichage, en période de rafraîchissement, en période de retour ligne, ou en période de retour trame.

5. Système graphique selon la revendication 4, le dit processeur d'écran comportant une mémoire premier entré premier sorti (ci-après FIFO) pour mémoriser les pixels à afficher, la dite FIFO émettant un signal (BUSY) lorsqu'elle est pleine, caractérisé en ce que le dit automate est agencé pour, lors de la réception dudit signal (BUSY), interrompre la lecture en rafale en cours et, le cas échéant, satisfaire une éventuelle demande d'accès pré-sélectionnée en attente.

6. Système graphique selon l'une quelconque des revendications 1, 2, 3, 4, 5, la dite DRAM pouvant être organisée selon un mode d'organisation à choisir parmi soit le mode quatre bit, soit le mode page, et, dans le cas du mode page, avec ou sans entrelacement des bancs mémoire, le dit choix étant initialement effectué à l'initiative du micro-ordinateur de commande puis mémorisé dans des registres (INIREG) du contrôleur de DRAM caractérisé en ce que le dit automate est connecté (MODE) aux dits registres et est agencé pour générer des séquences de signaux de contrôle de la DRAM conformes au dit choix du mode d'organisation.

7. Système graphique selon la revendication 6, caractérisé en ce que le dit automate comporte 21 états conformément au tableau A de la description, et en ce que le séquencement de ces dits états y est conditionné conformément au tableau B de la description.

8. Système graphique selon l'une quelconque des revendications précédentes caractérisé en ce que le dit automate est réalisé sous forme de réseau logique programmable (PLA).

9. Contrôleur graphique pour un système graphique selon l'une quelconque des revendications précédentes.

10. Contrôleur de DRAM pour un contrôleur graphique selon la revendication 9.

16

FIG. 1

EP 0 322 065 A1

1-Ⅳ-PHF 87-607

**FIG. 2**

DRAM

CT. DRAM

DAT CTRL

MEM CTRL

AD CTRL

AUTO

DCLP

INIREG

DIS CTRL

FR CTRL

BUSAR

SYN

MEMSEL 2

MEMCON

ADD SEL

MODE

BUSAD

FINCYC

ZERO

DV

DIN

BUSY

REQFR

LOAD 3

MEMSEL 1

LOAD 1

LOAD 2

REQ S

PERIOD

REQ 1

REQ 2

REQ 3

CTRL

32

9

32

21

32

32

20

FIG. 3

FIG. 4

REFRESH

PAGE

NIBBLE

INTER

EP 0 322 065 A1

4-IV-PHF 87-607

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | FR-A-2 593 304 (INTEL CORP.)<br>* Figure 1; page 1, lignes 26-28; page 2, lignes 1-11; page 4, lignes 15-28 * | 1 | G 09 G 1/00<br>G 09 G 1/16 |
| A | ELECTRONIC DESIGN, vol. 34, no. 22, 18 septembre 1986, pages 138-141, Hasbrouck Heights, New Jersey, US; N. SIDDIQUE: "100-MHz DRAM controller sparks multiprocessor designs"<br>* Page 138, colonne de droite, lignes 5-18 * | 1 | |
| A | GB-A-2 179 227 (CADTRAK)<br>* Figures 2-8; résumé; page 1, lignes 113-127; page 2, ligne 37 - page 5, ligne 59 * | 1 | |

**DOMAINES TECHNIQUES RECHERCHES (Int. Cl.4)**

G 09 G 1/00
G 11 C 11/406
G 09 G 1/16

**Le présent rapport a été établi pour toutes les revendications**

| Lieu de la recherche | Date d'achèvement de la recherche | Examinateur |
|---|---|---|
| LA HAYE | 06-04-1989 | VAN ROOST L.L.A. |

CATEGORIE DES DOCUMENTS CITES

X : particulièrement pertinent à lui.seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................................
& : membre de la même famille, document correspondant

EPO FORM 1503 03.82 (P0402)